# EUROPEAN PATENT APPLICATION

(11) **EP 4 831 557 A1**
(43) Date of publication of application: **28.10.2026**
(21) Application number: 26160316.1
(22) Date of filing: 24.02.2026
(51) Int. Cl.: F25B 25/00, F24F 5/00, F25B 47/00, F25B 49/02, F25D 17/02

(54) **LIQUID CIRCULATION APPARATUS, SUBSTRATE PROCESSING APPARATUS, AND METHOD OF MANUFACTURING PRODUCT**

(30) Priority: 26.02.2025 JP 2025029310
(71) Applicant: Canon Kabushiki Kaisha, Tokyo 146-8501 (JP)
(72) Inventor: SHIMIZU, Hiroki, Ohta-ku, Tokyo, 146-8501 (JP); NOMOTO, Makoto, Ohta-ku, Tokyo, 146-8501 (JP)
(74) Representative: TBK

(57) **Abstract**

A liquid circulation apparatus for cooling a heat generating part, including: a circulation path of a liquid; a deoxygenation unit that is provided on the circulation path and reduces oxygen in the liquid; and an evaporation reduction unit for reducing the amount of evaporation of the liquid.

## Description

### TECHNICAL FIELD

The present disclosure relates to a liquid circulation apparatus, a substrate processing apparatus, and a method of manufacturing a product.

### BACKGROUND

Semiconductor manufacturing apparatuses such as pattern forming apparatuses including an exposure apparatus, an imprint apparatus, and an electron beam drawing apparatus or plasma processing apparatuses such as a CVD apparatus, an etching apparatus, and a sputtering apparatus have heat generating parts such as drive mechanisms or members that are heated by plasma.

In order to cool such a heat generating part, a cooling device may be provided in a semiconductor manufacturing apparatus. The cooling device cools the heat generating part by removing heat from the heat generating part and discharging the heat to the outside of the apparatus. As systems for cooling heat generating parts, liquid circulation systems such as refrigerators or chillers are generally used.

A liquid circulation facility described in Japanese Patent Application Laid-Open No. 2004-77054 requires makeup water due to evaporation of circulation liquid even in a closed circulation facility. In a case in which the makeup water contains oxygen, corrosion occurs inside the piping, and thus a system in which oxygen in the makeup water is removed, and the makeup water is supplied to the circulation system has been disclosed. By removing oxygen from a liquid supplied to a circulation system in advance, corrosion that might occur in a device or piping can be suppressed.

Japanese Patent Application Laid-Open No. 2004-77054 is an example of related art.

Although the liquid circulation system described in Japanese Patent Application Laid-Open No. 2004-77054 requires replenishment of a circulation liquid, depending on the properties of the circulation liquid, evaporation may cause changes in the concentration of the liquid. For simple diluted mixtures or the like, a concentration adjustment operation can be performed as needed while the concentration of the circulation liquid is checked. However, in a case in which the circulation liquid is a mixture of liquids with different vapor pressures, it is difficult to maintain the concentration of the circulation liquid.

### SUMMARY

A liquid circulation apparatus according to one aspect of the present disclosure is a liquid circulation apparatus for cooling a heat generating part, the liquid circulation apparatus including: a circulation path of a liquid; a deoxygenation unit that is provided on the circulation path and reduces oxygen in the liquid; and an evaporation reduction unit for reducing the amount of evaporation of the liquid.

Further features of the present disclosure will become apparent from the following description of embodiments with reference to the attached drawings.

### BRIEF DESCRIPTION OF THE DRAWINGS

Fig. 1 is a schematic diagram illustrating a configuration example of a liquid circulation system according to a first embodiment.
Fig. 2 is a diagram illustrating an example of a saturation vapor pressure curve of water.
Fig. 3 is a diagram illustrating another example of an evaporation reduction means according to the first embodiment.
Fig. 4 is a schematic diagram illustrating a configuration example of a liquid circulation system according to a second embodiment.
Fig. 5 is a schematic diagram illustrating a configuration example of a substrate processing apparatus according to an embodiment.

### DESCRIPTION OF THE EMBODIMENTS

Hereinafter, with reference to the accompanying drawings, favorable modes of the present disclosure will be described using Embodiments. In each diagram, the same reference signs are applied to the same members or elements, and duplicate description will be omitted or simplified.

In this specification and the attached drawings, directions are indicated using an XYZ coordinate system having an XY plane in a direction parallel to the surface (the surface to be processed) of a substrate. Directions parallel to the X axis, the Y axis, and the Z axis in the XYZ coordinate system are respectively denoted by an X direction, a Y direction, and a Z direction, and the rotation around the X axis, the rotation around the Y axis, and the rotation around the Z axis are respectively denoted by θX, θY, and θZ.

### <First Embodiment>

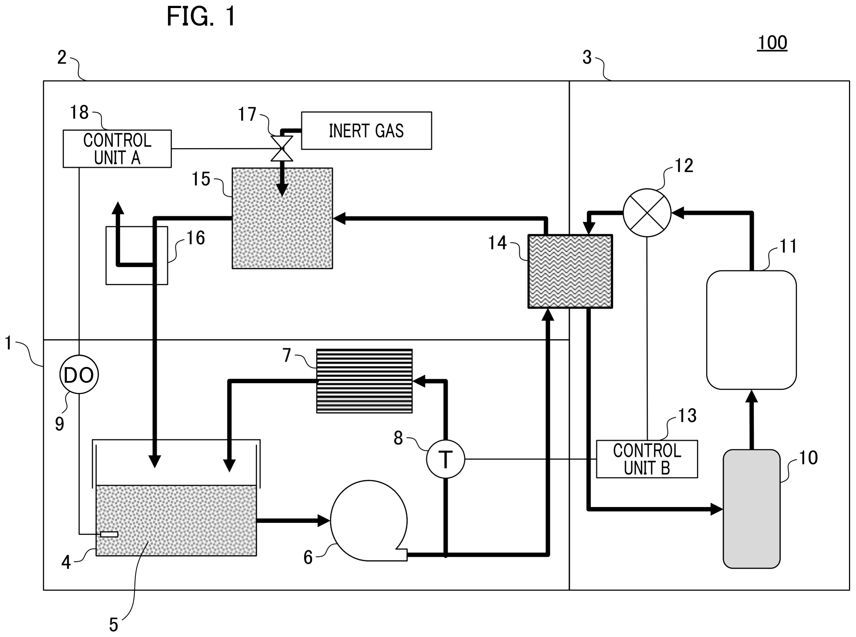

Hereinafter, the present disclosure is described with reference to the attached drawings using exemplary embodiments thereof. Fig. 1 is a schematic diagram illustrating a configuration example of a liquid circulation system (liquid circulation apparatus) 100 according to a first embodiment. The liquid circulation system 100 includes a liquid circulation unit 1, an evaporation reduction unit 2, and a cooling system 3. The liquid circulation system 100 performs heat dissipation and temperature control of a heat generating part 7, which is described below, using a circulation liquid 5.

The liquid circulation unit 1 includes a tank 4, a pump 6, a temperature sensor 8 (first measurement unit), and a dissolved-oxygen meter 9. A circulation liquid 5 is filled into the tank 4. In the liquid circulation system, examples of coolants that are commonly used in a circulation liquid include water and a glycol-based fluid.

Water has a high specific heat capacity and a good heat recovery efficiency and thus is frequently used as a useful coolant. Examples of the glycol-based fluids include ethylene glycol and propylene glycol. Ethylene glycol and propylene glycol have a function of lowering a freezing point when mixed with water and are used as antifreeze.

In addition, there are coolants that can suppress metal corrosion when preservatives or rust inhibitors are added thereto. The temperature sensor 8 is arranged upstream of the heat generating part 7 and measures the temperature of the circulation liquid 5 upstream of the heat generating part 7. The pump 6 is arranged downstream of the tank 4.

The dissolved-oxygen meter 9 measures the amount of dissolved oxygen in the circulation liquid 5 inside the tank 4. In the liquid circulation system 100 according to the present embodiment, the circulation liquid 5 filled into the tank 4 is branched into two parts downstream of the pump 6, and the branched liquids are supplied to the heat generating part 7 and the evaporation reduction unit 2.

The circulation liquid 5 supplied to the heat generating part 7 recovers the heat of the heat generating part 7 and returns the heat to the tank 4. In other words, after circulating through a circulation path, the circulation liquid 5 is returned to the tank 4. The heat generating part 7 is, for example, a coil that generates heat in accordance with driving.

The evaporation reduction unit 2 includes a cooler 14 (cooling unit) to which one of the circulation paths branched by the pump 6 is connected, a deoxygenation unit 15 that supplies an inert gas, and a gas-liquid separation unit 16. The evaporation reduction unit 2 is an evaporation reduction means for reducing the evaporation amount of the circulation liquid 5.

Although there are cases in which metal piping with high thermal conductivity is used in cooling piping in order to improve the cooling efficiency of the liquid circulation system, if oxygen is dissolved in the circulation liquid, it can cause corrosion of the metal piping. More particularly, although it is preferable to use copper from the viewpoint of thermal conductivity, corrosion of copper pipes is well known as a common problem in water that is frequently used as a circulation liquid.

As the phenomenon of corrosion, first, cuprous oxide is generated through an oxidation reaction of copper. Generally, cuprous oxide exhibits good corrosion resistance as long as it is in a stable environment. However, when time elapses, basic copper carbonate, basic copper sulfate, basic copper chloride, and the like are generated in an oxide coating film of cuprous oxide or the like, the adhesion of the coating film is insufficient, and thus it is not helpful for the prevention of corrosion of copper.

When such corrosion occurs, corrosion products are mixed into the circulation liquid, which cause problems such as filter clogging and an increase in the flow resistance of piping. For this reason, in a liquid circulation system, although it is considered to use corrosion-resistant metal piping, a corrosion-inhibiting circulation liquid, and the like, in the present embodiment, metal corrosion is suppressed by reducing the amount of dissolved oxygen in the circulation liquid 5.

Metal corrosion is an oxidation reaction, and a reduction reaction corresponding thereto involves dissolved oxygen. For this reason, if there is no dissolved oxygen for causing a reduction reaction, an oxidation reaction does not occur, and thus the metal corrosion can be suppressed.

In the evaporation reduction unit 2, the circulation liquid 5, first, delivered to the cooler 14 is cooled by the cooling system 3, passes through the deoxygenation unit 15, and is returned to the tank 4. In other words, the cooler 14 is provided upstream of the deoxygenation unit 15 in a circulation path.

In the deoxygenation unit 15, oxygen in the circulation liquid 5 is reduced. More specifically, in the deoxygenation unit 15, an inert gas with a low oxygen partial pressure is introduced into the circulation liquid 5, whereby a gas-liquid two-phase flow of the circulation liquid 5 and the inert gas is generated.

In accordance with this, oxygen contained in the circulation liquid 5 moves to the inert-gas side, and by discharging the inert gas of which the oxygen partial pressure has increased, the amount of dissolved oxygen in the circulation liquid can be reduced. As the inert gas, for example, nitrogen gas can be used.

As a method for supplying inert gas in the deoxygenation unit 15, bubbling in the liquid is preferred. In inert-gas aeration above a liquid surface, since a deoxygenation process is performed only between a gas phase and the liquid surface, a contact area of the bubble surface can be increased in bubbling in the liquid.

Moreover, since an inert gas with a low oxygen partial pressure has a low vapor pressure, it can be expected to promote the effect of reducing dissolved oxygen. However, at the same time, it also absorbs moisture of the circulation liquid 5 and causes it to evaporate.

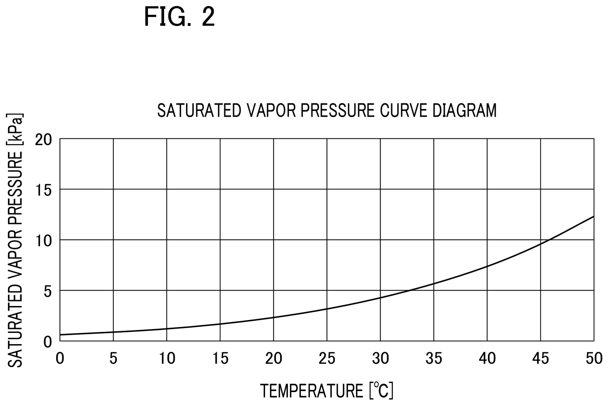

The amount of evaporation is determined on the basis of the saturated vapor pressure of the circulation liquid 5. The saturated vapor pressure can be represented by a saturated vapor pressure curve. Fig. 2 is a diagram illustrating an example of the saturated vapor pressure curve of water. In this drawing, the horizontal axis represents temperature, and the vertical axis represents saturated vapor pressure. The saturated vapor pressure of water can be acquired using the following Tetens' equation. $\begin{matrix}e \left(T\right) = 6.1078 \times {10}^{\left(7.5⋅T/\left(T+237.3\right)\right)} \\ T : temperature\end{matrix}$ (1)

As illustrated in this drawing, the saturated vapor pressure curve of water becomes an upward-sloping curve.

The saturated vapor pressure value is proportional to temperature, the higher the saturated vapor pressure, the easier the evaporation, and the lower the saturated vapor pressure, the more difficult the evaporation. For this reason, by employing a structure in which the cooler 14 is arranged in the evaporation reduction unit 2, and feeding the circulation liquid 5, which has been cooled by the cooling system 3, to the deoxygenation unit 15, the saturated vapor pressure is lowered, whereby the evaporation of the circulation liquid 5 can be reduced.

When the circulation liquid 5, which supplies inert gas is water, the saturated vapor pressure at the temperature of 25 °C is 3,169 Pa in accordance with the Tetens' equation. In a case in which the temperature of water is 0 °C, the saturated vapor pressure becomes 611 Pa, and thus when compared to the case of temperature 25 °C, there is an effect of evaporation speed reduction of the saturation evaporation pressure ratio 81% in a case in which the temperature of water is 0 °C.

The gas-liquid separation unit 16 is arranged upstream of the tank 4 and separates gas from the circulation liquid 5. The inert gas introduced into the circulation liquid needs to be vented, because if it is not vented, the pressure inside of the circulation system continues to rise, which may lead to device damage.

Since the high-temperature circulation liquid 5 of which heat has been recovered from the heat generating part 7 also returns to the inside of the tank 4, if the inert gas is vented from the tank 4, the high-temperature circulation liquid 5 comes into contact with the inert gas at the liquid surface and evaporates.

Therefore, by providing the gas-liquid separation unit 16 upstream of the tank 4, the inert gas introduced into the circulation liquid 5 by the deoxygenation unit 15 can be separated into gas and liquid and vented, and only the circulation liquid 5 after deoxygenation 5 can be returned to the inside of the tank.

According to this method, the system can be configured as a semi-closed circulation system, and outside air does not enter the inside of the tank 4, and thus evaporation can be further reduced. In addition, by configuring the semi-closed circulation system, oxygen can be prevented from dissolving from the outside air.

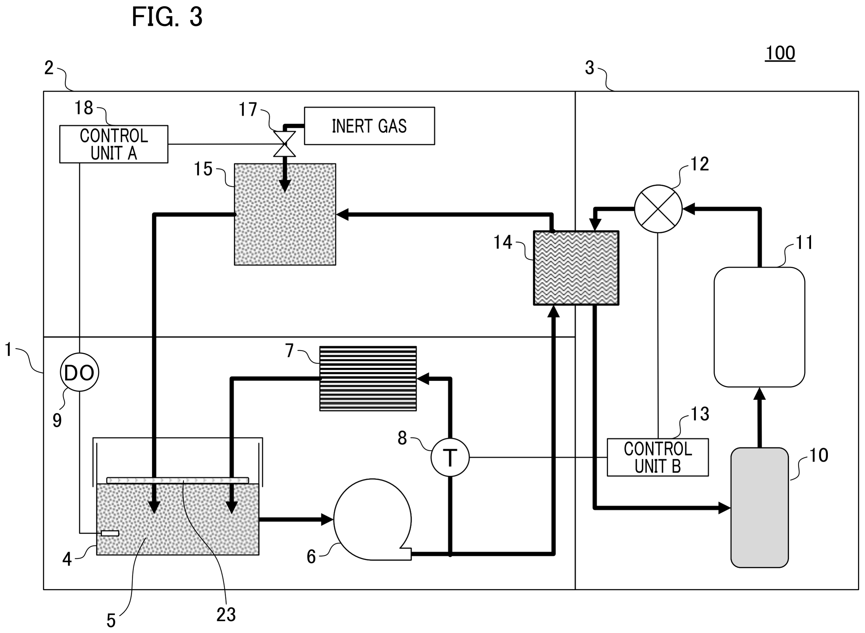

Fig. 3 is a diagram illustrating another example of an evaporation reduction means according to the first embodiment. As an evaporation reduction means other than the gas-liquid separation unit 16, for example, as illustrated in Fig. 3, a floating lid 23 (lid part) that covers the liquid surface of the circulation liquid 5 inside the tank 4 may be provided.

By placing the floating lid 23 on the liquid surface of the circulation liquid 5 inside the tank 4, a physical contact area between the inert gas and the liquid surface of the circulation liquid 5 can be reduced. In other words, here, the floating lid 23 functions as a part of the evaporation reduction unit.

At this time, the circulation liquid 5 returning to the tank 4 evaporates much also in accordance with coming into contact with the gas phase inside the tank 4. For this reason, it is preferable that the circulation liquid 5 returning to the tank 4 should be directly discharged into a filling liquid of the tank 4. In accordance with this, the evaporation of the circulation liquid 5 and the dissolution of oxygen can be effectively suppressed.

The evaporation reduction unit 2 further includes a control valve 17 and a control unit A 18 (third control unit). The control valve 17 is a flow control valve of which the opening degree can be adjusted. The amount of dissolved oxygen of the circulation liquid 5 can be measured by a dissolved-oxygen meter 9 (third measurement unit) included inside of the tank 4.

The control unit A 18 acquires a measurement result of the dissolved-oxygen meter 9, that is, a measurement value of the dissolved-oxygen meter 9. The control unit A 18 performs control of the degree of opening of the control valve 17 on the basis of the measurement result of the dissolved-oxygen meter 9, that is, the measured value of the dissolved-oxygen meter 9 such that the amount of dissolved oxygen in the circulation liquid 5 becomes a desired value.

More specifically, the control unit A 18 increases the degree of opening of the control valve 17 to increase the amount of the flow of inert gas until the measured value of the dissolved-oxygen meter 9 becomes a predetermined value. In accordance with this, the dissolved oxygen of the circulation liquid 5 can be quickly removed.

In accordance with such a configuration, the influence of metal corrosion at the time of erecting a device can be decreased as possibly. In addition, when the amount of dissolved oxygen measured by the dissolved-oxygen meter 9 becomes a predetermined numerical value or less, the control unit A 18 decreases the degree of opening of the control valve 17, and thus the amount of use of the inert gas can be decreased. In accordance with this, the operation can be performed with only the minimum necessary usage amount of inert gas all the time, which leads to the reduction of inert-gas operating costs.

The cooling system 3 discharges heat that has been collected inside the circulation system by the circulation liquid 5 of the liquid circulation unit 5 to the outside. More specifically, the cooling system 3 is a refrigerant circulation system that includes a compressor 10, a condenser 11, and an expansion valve 12 (first expansion valve).

A liquid-phase refrigerant is depressurized to a required vapor pressure by the expansion valve 12, absorbs the heat of the heat generating part 7 of the liquid circulation unit 1 through a phase change to vapor, is then pressurized by the compressor 10, releases heat to a heat-dissipating medium, which is not illustrated, in the condenser 11, condenses into a liquid phase, and circulates.

The expansion valve 12 can adjust the amount of refrigerant fed (supplied) to the cooler 14 by adjusting the degree of opening. In the present embodiment, although the cooling system 3 uses the configuration of a general refrigeration unit as an example, the liquid flowing to the cooler 14 may be low-temperature cooling water or the like as long as the heat of the circulation liquid 5 can be recovered.

The cooling system 3 further includes a control unit B 13 (first control unit). The temperature of the circulation liquid 5 on the upstream side of the heat generating part 7 can be measured by the temperature sensor 8. The control unit B 13 acquires a measurement result of the temperature sensor 8, in other words, reads a measurement value from the temperature sensor 8.

The control unit B 13 performs control of the degree of opening of the expansion valve 12 on the basis of the measurement result acquired by the temperature sensor 8, that is, a measured value acquired by the temperature sensor 8 such that the temperature of the circulation liquid 5 becomes a desired value. More specifically, the control unit B 13 adjusts the flow rate of the refrigerant flowing to the cooler 14 by controlling the degree of opening of the expansion valve 12 such that the measurement value acquired by the temperature sensor 8 becomes a predetermined numerical value, that is, a target temperature.

In addition, a temperature sensor may be further provided upstream of the deoxygenation unit 15 and downstream of the cooler 14. For example, the control unit B 13 controls the degree of opening of the expansion valve 12 on the basis of a measurement result acquired by the temperature sensor provided upstream of the deoxygenation unit 15 and downstream of the cooler 14. In accordance with this, the temperature of the circulation liquid 5 fed to the deoxygenation unit 15 can be caused to approach a more desired temperature, whereby the evaporation of the circulation liquid 5 can be reduced further.

As above, according to the present embodiment, in a liquid circulation system that performs deoxygenation processing reducing oxygen in the circulation liquid, the evaporation of the circulation liquid can be reduced.

### <Second Embodiment>

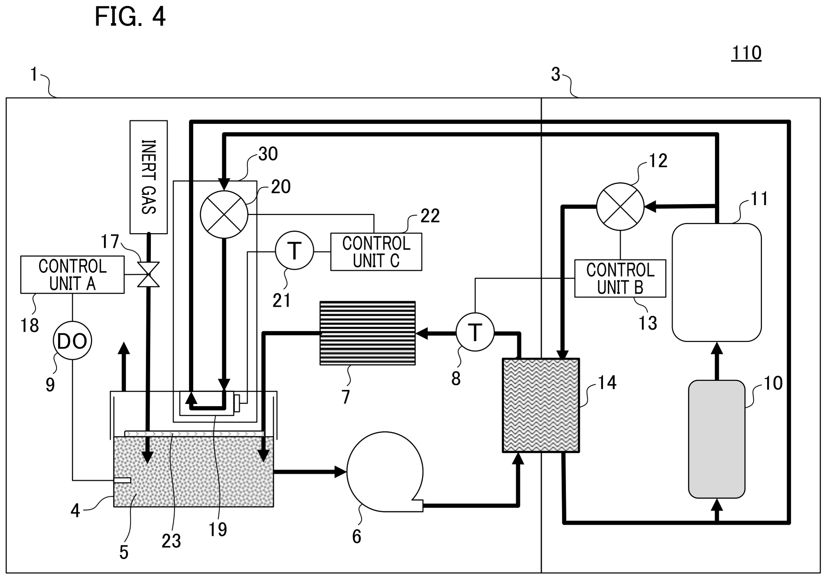

Next, a liquid circulation system 110 according to a second embodiment is described with reference to Fig. 4. Fig. 4 is a schematic diagram illustrating a configuration example of the liquid circulation system 110 according to the second embodiment. The liquid circulation system 110 according to the second embodiment includes a condensation unit 30 as an evaporation reduction unit. Matters not mentioned in the second embodiment follow the first embodiment.

The condensation unit 30 includes an expansion valve 20 (second expansion valve) and a recovery condenser 19 that has an internal flow passage through which refrigerant discharged from the expansion valve 20 flows. In the liquid circulation system 110 according to the second embodiment, a branch pipe is provided on the outlet side of a condenser 11 configured in the cooling system 3, and refrigerant is fed to an expansion valve 12 for the cooler 14 and the expansion valve 20 for the recovery condenser 19.

The refrigerant discharged from the expansion valve 12 for the cooler 14 is fed to the cooler 14, and the refrigerant discharged from the expansion valve 20 for the recovery condenser 19 is fed to the recovery condenser 19 provided inside the tank 4.

The condensation unit 30 further includes a temperature sensor 21 (second measurement unit) and a control unit C 22 (second control unit). The temperature sensor 21 measures the temperature of the refrigerant flowing inside of the recovery condenser 19. The control unit C 22 acquires a measurement result acquired by the temperature sensor 21, in other words, reads a measurement value from the temperature sensor 21.

The control unit C 22 performs control of the degree of opening of the expansion valve 20 on the basis of the measurement result acquired by the temperature sensor 21, that is, the measurement value acquired by the temperature sensor 21 such that the temperature of the refrigerant flowing inside of the recovery condenser 19 becomes a desired value.

More specifically, the control unit C 22 adjusts the flow rate of the refrigerant flowing to the recovery condenser 19 by controlling the degree of opening of the expansion valve 20 such that the measurement value acquired from the temperature sensor 21 becomes a predetermined value, in other words, the temperature of the recovery condenser 19 becomes a freezing point of the circulation liquid 5 or less.

When refrigerant is fed to the recovery condenser 19, the recovery condenser 19 comes into a cooled state, and the circulation liquid 5 that has evaporated in accordance with the circulation liquid 5, which has evaporated in the tank, coming into contact with the recovery condenser 19 is re-condensed into water drops and returns to the circulation liquid 5 in the tank.

According to the second embodiment, since the circulation liquid 5 that has evaporated can be directly condensed and returned, the fill amount of the circulation liquid 5 can be maintained, and thus, maintenance costs, a liquid replenishment operation, and a maintenance operation for the adjustment of circulation liquid concentration can be reduced.

### <Substrate Processing Apparatus According to Embodiment>

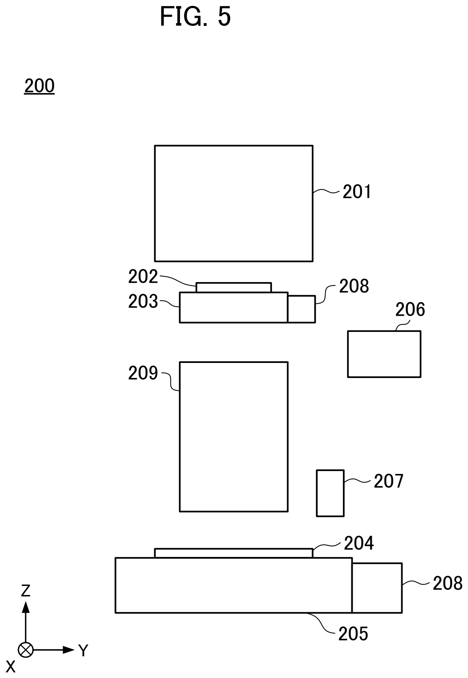

Fig. 5 is a schematic diagram illustrating a configuration example of the substrate processing apparatus according to an embodiment. The liquid circulation system according to the embodiments described above can be applied to a substrate processing apparatus used when products such as semiconductor devices are manufactured. The substrate processing apparatus is a lithography apparatus for manufacturing products such as semiconductor devices using a lithography apparatus.

A lithography apparatus is an apparatus that is employed in a lithography process, which is a manufacturing process for semiconductor devices or liquid crystal display devices, and forms patterns on a substrate. Examples of the lithography apparatus include an exposure apparatus that transfers a pattern of a master on a substrate by exposing the substrate through the master and an imprint apparatus that forms a pattern on an imprint material on the substrate using a mold as the master. Hereinafter, an exposure apparatus 200 as the substrate processing apparatus is described as an example.

In the present embodiment, the exposure apparatus 200 is a projection exposure apparatus that exposes the pattern of a master (mask, reticle) onto a substrate through a projection optical system using a step-and-repeat type or a step-and-scan type.

The exposure apparatus 200 includes an illumination optical system 201 that emits light, a projection optical system 209, a reticle stage 203 that holds a reticle 202, a substrate stage 205 that holds the substrate 204, a control unit 206, a measurement unit 207, and a liquid circulation system 208.

The reticle 202 is, for example, a master in which a pattern to be transferred (for example, a circuit pattern) is formed on the surface of a quartz glass using chromium. The substrate 204 is, for example, single-crystal silicon, and has a surface coated with a photosensitive material (resist).

The reticle stage 203 holds the reticle 202 and can be driven, for example, by a linear motor having a coil. The substrate stage 205 holds the substrate 204 and can be driven, for example, by a linear motor having a coil.

The control unit 206 controls each part of the exposure apparatus 200. The measurement unit 207 measures the height position of the substrate 204 held by the substrate stage 205. The liquid circulation system 208, for example, cools the coil of the substrate stage 205 described above.

Since the substrate stage 205 (also the reticle stage 203 in the case of the exposure apparatus of the step-and-scan type) is driven at high speed and high acceleration, the coil constituting the linear motor as a stage drive source generates a large amount of heat. For this reason, the coil is cooled using the liquid circulation system 208. In other words, the coil corresponds to the heat generating part in the liquid circulation system 208.

In the exposure apparatus 200, exposure light from a light source (not illustrated) illuminates the reticle 202 held on the reticle stage 203 through the illumination optical system 201. The light that has passes through the reticle 202 is projected onto the substrate 204 through the projection optical system 209.

At this time, the light from the pattern formed on the reticle 202 forms an image on the surface of the substrate 204, and shot areas of the substrate 204 (photosensitive material) are exposed in accordance with the pattern image. In this manner, the exposure apparatus 200 exposes the shot areas on the substrate 204 and similarly performs the exposure for each of a plurality of shot areas.

### <Product Manufacturing Method According to Embodiment>

The lithography apparatus as described above can be used to implement methods for manufacturing various products (semiconductor IC devices, liquid crystal display devices, MEMS, and the like). The product manufacturing method according to an embodiment of the present disclosure is, for example, suitable for manufacturing products such as devices (semiconductor elements, magnetic storage media, liquid crystal display elements, and the like).

Such a product manufacturing method includes a processing step of processing a master using the above-described processing method (information processing apparatus) and a transfer step of transferring the pattern of the master processed in the processing step onto a substrate. In addition, the product manufacturing method includes a processing step of processing the substrate after the transfer step and a manufacturing step of manufacturing a product from the substrate that has undergone the processing step.

Furthermore, such a product manufacturing method may include other well-known steps (oxidation, film formation, deposition, doping, planarization, etching, resist removal, dicing, bonding, packaging, and the like). The product manufacturing method according to the present embodiment is advantageous, compared to conventional methods, in at least one of the performance, quality, productivity, and production cost of products.

In the above-described embodiments, although an example in which the liquid circulation system is applied to an exposure apparatus as a substrate processing apparatus has been described, it can also be applied to various devices such as industrial machinery, medical equipment, scientific instruments, and food processing equipment.

While the present disclosure has been described with reference to embodiments, it is to be understood that the disclosure is not limited to the disclosed embodiments. The scope of the following claims is to be accorded the broadest interpretation so as to encompass all such modifications and equivalent structures and functions.

This application claims the benefit of Japanese Patent Application No. 2025-029310, filed on February 26, 2025, which is hereby incorporated by reference herein in its entirety.

## Claims

1. A liquid circulation apparatus for cooling a heat generating part, the liquid circulation apparatus comprising:
a circulation path of a liquid;
a deoxygenation unit that is provided on the circulation path and reduces oxygen in the liquid; and
an evaporation reduction unit for reducing the amount of evaporation of the liquid.

2. The liquid circulation apparatus according to claim 1, wherein the evaporation reduction unit includes a cooling unit that is provided upstream of the deoxygenation unit and cools the liquid in the circulation path.

3. The liquid circulation apparatus according to claim 2, further comprising:
a first measurement unit that measures a temperature of the liquid in the circulation path;
a first expansion valve for feeding refrigerant to the cooling unit; and
a first control unit that controls a degree of opening of the first expansion valve on the basis of a measurement result acquired by the first measurement unit.

4. The liquid circulation apparatus according to claim 3, wherein the first measurement unit is provided upstream of the heat generating part.

5. The liquid circulation apparatus according to claim 3 or 4 , wherein the first measurement unit is provided upstream of the deoxygenation unit and downstream of the cooling unit.

6. The liquid circulation apparatus according to any one of claims 1 to 5, wherein the evaporation reduction unit includes a condensation unit that condenses vapor of the liquid inside of a tank filled with the liquid.

7. The liquid circulation apparatus according to claim 6, wherein the condensation unit includes:
a recovery condenser that is provided inside of the tank;
a second measurement unit that measures a temperature of refrigerant flowing inside of the recovery condenser;
a second expansion valve for feeding the refrigerant to the recovery condenser; and
a second control unit that controls a degree of opening of the second expansion valve on the basis of a measurement result acquired by the second measurement unit.

8. The liquid circulation apparatus according to any one of claims 1 to 7, wherein the evaporation reduction unit includes a lid part that covers a liquid surface of the liquid inside of a tank filled with the liquid.

9. The liquid circulation apparatus according to any one of claims 1 to 8, further comprising a third measurement unit that measures an amount of dissolved oxygen in the liquid filled inside of a tank,
wherein the deoxygenation unit includes:
a flow control valve for introducing inert gas into the liquid; and
a third control unit that controls a degree of opening of the flow control valve on the basis of a measurement result acquired by the third measurement unit.

10. The liquid circulation apparatus according to claim 9, wherein the deoxygenation unit includes a gas-liquid separation unit that separates vapor from the liquid after introduction of the inert gas.

11. The liquid circulation apparatus according to any one of claims 1 to 10, wherein the liquid is discharged into a filling liquid inside of a tank filled with the liquid after circulation along the circulation path.

12. A substrate processing apparatus processing a substrate, the substrate processing apparatus comprising:
the liquid circulation apparatus according to any one of claims 1 to 11.

13. A method of manufacturing a product, the method comprising:
processing a substrate using the substrate processing apparatus according to claim 12; and
manufacturing a product from the processed substrate.
